(19) Europäisches Patentamt / European Patent Office / Office européen des brevets

(11) **EP 2 051 175 A1**

(12) **EUROPEAN PATENT APPLICATION**

(43) Date of publication:
**22.04.2009 Bulletin 2009/17**

(51) Int Cl.:
***G06F 17/50*** (2006.01)

(21) Application number: **07118724.9**

(22) Date of filing: **17.10.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicants:
• **IBBT vzw**
**9050 Gent (BE)**
• **Ghent University**
**9000 Gent (BE)**

(72) Inventors:
• **Deschrijver Dirk**
**9700 Oudenaarde (BE)**
• **Dhaene, Tom**
**9800 Deinze (BE)**
• **De Zutter Daniel**
**9900 Eeklo (BE)**

(74) Representative: **Plas, Axel Ivo Michel et al**
**BiiP cvba**
**Culliganlaan 1B**
**1831 Diegem (Brussels) (BE)**

(54) **Method and device for generating a model of a multiparameter system**

(57)    The present invention relates to a method (200) for generating a multivariate system model of a multivariate system which has a plurality of parameters and the multivariate system model is representative for the system response to changes in the parameters. The method (200) involves performing a plurality of measurements and/or simulations on the multivariate system to obtain reference data (201). The method further involves the selection of rational base functions (202) and combining these base functions (203) into a model of the multivariate system. The multivariate system model is obtained (208) by minimizing a cost function (205) between the model and the reference data. Explicit weight factors which are related to the reference data are used. The respective values for the explicit weight factors in the cost function are iteratively determined (205) in order to approximate the reference data with the model and the cost function is updated accordingly in each iteration.

Fig. 2

**Description**

**Field of the Invention**

The present invention generally relates to generating models of Linear Time-Invariant (LTI) systems and more in particular to generating models of multivariate systems, i.e. systems that are responsive to variations in two or more parameters. The practice of the present invention can be used for instance to model responses of electronic circuits to variations in plural parameters such as for instance the typically highly dynamic frequency dependent behaviour, systems for signal processing, control theory mechanical systems, etc. The present invention further can advantageously be used for macro-modelling for the design, study and optimization of microwave structures.

**Background of the Invention**

Modelling systems in various fields of technology allow designers and researchers to study input and outputs or action and reaction based on a theoretical representation of the system. For instance, a model of a system with multiple inputs and multiple outputs enables a designer or researcher to understand and determine how outputs respond to particular input signals over a wide range of frequencies. Such system that is modelled with a single parameter such as frequency is called a univariate system. The problem of modelling a system obviously becomes more complex when multiple parameters are to be taken into consideration. For instance a model taking geometrical specifications, characteristics of the materials and the frequency as parameters would constitute a multivariate system.

A paper titled "Adaptive Multivariate Rational Data Fitting With Applications in Electromagnetics" by Annie Cuyt et. al. which was published on May 5th 2006 in the IEEE transactions on microwave theory and techniques, Volume 54, no. 5 discloses a mathematical approach to modelling multivariate systems.

The paper teaches a method for modelling multivariate systems based on interpolating data samples which are scattered in the multivariate space. This prior art requires that optimally located positions of the data samples are used, preferably grid-structured data samples. Although the paper notes that the use of non-grid structured data samples is possible, this is left for further study. A first drawback of the method known from Annie Cuyt et. al. is that optimally located data samples may be hard to achieve because they require a technique to determine the optimal location of data samples. Such a technique makes the overall method more complex and may increase overall computation time. In addition, it may be difficult or even impossible to obtain such optimally located data samples from a system by testing.

A second problem of the method described in the above mentioned paper results from the fact that the method is based on interpolation. Interpolation requires that the data samples are accurate. If the data samples are not accurate, the model obtained through Annie Cuyt's method will be incorrect and cannot be used reliably for its purpose. Thus, any data samples which are noisy generate an incorrect model of a system. Summarizing, the method disclosed in the paper needs optimally located data samples which are not noisy. As a consequence, the method is rather complex and may be very time consuming even before any modelling has occurred.

A third problem with the method described in Annie Cuyt's paper is that it is mainly designed to use real data samples and handles complex data samples by using the real parts and the imaginary parts independently. This works fine in a pure mathematical sense, but is less useful when applied in system theory, control techniques, etc. These fields typically rely on complex data to satisfy the causality of a system.

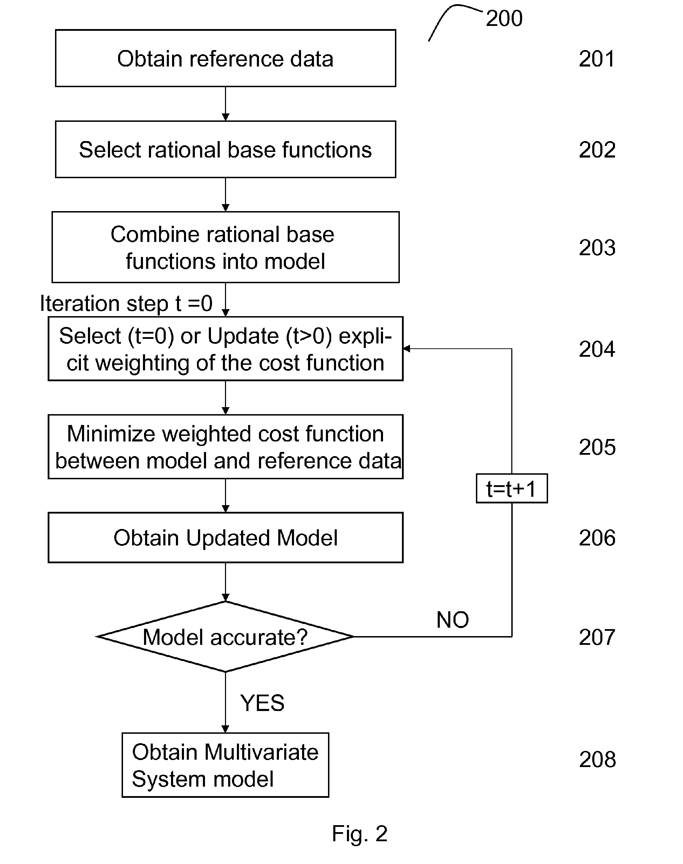

Yet another drawback is that the method as described in the paper is limited in complexity of the systems that can be modelled. High order systems may become too difficult to model using this method as is for instance illustrated in Fig. 2 (a) and (b) and Fig. 3 (a), (b), (c) and (d) of the paper. These figures show smooth surfaces as models, which illustrates that more complex or dynamic models are very hard if not impossible to model.

It is an objective of the present invention to provide a method for modelling multivariate systems that overcomes the drawbacks of the above cited prior art solution, more specifically, it is an objective of the present invention to provide a method for modelling multivariate systems which is less computational intensive and therefore faster in execution. It is another objective of the present invention to provide a method for modelling multivariate systems which does not rely on specifically chosen data samples. It is a further objective of the present invention to provide a method for modelling systems which can deal with noisy and eventually complex data samples.

**Summary of the Invention**

The objectives of the present invention are realized by a method for generating a multivariate system model of a multivariate system, the multivariate system having a plurality of parameters and the multivariate system model being representative for the system response to changes in the parameters, the method comprising the steps of:

- performing a plurality of measurements and/or simulations on the multivariate system to obtain reference data;

- selecting rational base functions;
- combining those base functions into a model of the multivariate system; and
- minimizing a cost function between the model and the reference data to obtain the multivariate system model of the multivariate system,

characterized in that the method further comprises the steps of:

- using explicit weight factors related to the reference data in the cost function;
- as part of minimizing the cost function, iteratively determining updated values for the explicit weight factors in the cost function in order to approximate the reference data with the model; and
- updating the cost function with the updated values for the explicit weight factors in each iteration.

Thanks to explicit weighing and iterative approximation of reference data, there is no need for accurate, noise free reference data and no need for positioning the data samples optimally. As a consequence, there is a reduction in the required processing or computation time and the method is faster. Furthermore, by updating the weight factors in each iteration, the accuracy of the model and the convergence of the iteration is improved.

The multivariate system model which is the result of the method of the present invention is an accurate approximation of the reference data obtained from the multivariate system by the model instead of an interpolated model through the data samples. The approximation of the reference data with the model is obtained iteratively The multivariate system model may be an exact match in some or all of the reference data but need not be so. The iteration process involves repeatedly determining new values for the explicit weight factors until certain conditions are met. For instance, if the model is within a particular range of all reference data, it may be considered accurate enough to be used as multivariate system model. Other options are for instance to consider the required time to calculate additional iterations and the significance of the changes in the values as a result of these additional iterations, or a combination of the foregoing. In general, the iteration process will end when the model is considered accurate enough for its purpose or when additional steps are deemed excessive. It is to be understood that the model as used in the present invention is a model of a multivariate system which may change during the application of the method. The multivariate system model obtained as the result of the steps constituting the method of the present invention can be used for purposes such as analysis, design and optimization of the multivariate system.

The reference data can be obtained by simulating the model and extracting information from the simulation results. Another way of obtaining reference data is by measuring information in the system itself. Alternatively, the reference data may be obtained by a combination of measurements and simulations. In general, any method that provides a number of reference data or data points that can be used to model the system can be used. An advantage of the method of the present invention is that the method is based on approximation of the reference data with the model in an iterative process. Thus, each iteration the model moves closer to match the reference data. The approximation has as advantageous result that any noise on the reference data, for instance noise due to incorrect measurements, has little effect on the accuracy of the model. In addition, an approximation is typically less demanding in calculation time than an exact match. As such, approximation may reduce the duration of the model generation. The accuracy of an exact match like the interpolation based method from A. Cuyt et al. is significantly improved by using a large set of reference data whereas approximation can be achieved with less reference data. This reduces the computation time or effort required to obtain the reference data and reduces the computation time for generating the multivariate system model. In addition, by adding a weight factor to the reference data, it is possible to define the importance of particular elements of the reference data. This influences the model and allows for the compensation of noisy data. For instance, if particular elements of the reference data are very noisy, their influence on the model may be reduce by adjusting their weight factor value.

The method of the present invention relies on a selection of base functions which are combined in a model of the multivariate system. However, merely combining the base functions is insufficient to obtain an accurate model. Therefore the cost function is updated by an explicit weight factor which improves the accuracy of the model in successive iterations..

The cost function is representative for the distance between the model and the reference data. By minimizing the cost function, the model moves closer to the reference data and once the cost function is minimized, the model approximates the reference data sufficiently to form the multivariate system model.

Optionally, the rational base functions are orthonormal rational base functions.

Optionally the plurality of parameters comprises one or more dynamic parameters and/or one or more property parameters.

Further optionally, the dynamic parameters are one or more of the following:

- frequency; and

- spatial frequency; and the property parameters are one or more of the following:

- geometrical parameters; and
- material characteristics; Various parameters define the system and generally these parameters fit in one of two categories. A first category contains parameters with a highly dynamic behaviour, in other words parameters which result in highly varying responses of the system. The second category includes parameters with a rather static behaviour or parameters which result in a rather smooth change in system response. Typical examples of the first category are parameters such as frequency and spatial frequency. Typical examples of the second category are geometrical parameters such as chip size, semiconductor length or width, etc, and material characteristics such as dielectric constant, resistance per length unit of a material, etc.

By considering the dynamics or type of parameters which are present in the multivariate system, it is possible to select base functions accordingly.

Optionally, the base functions in the method for generating a model of a multivariate system according to the present invention are rational functions, Muntz-Laguerre functions, Kautz functions or pole-residue functions for the dynamic parameters and the base functions are rational or polynomial functions for the property parameters.

Base functions such as Muntz-Laguerre functions or Kautz functions are able to model highly dynamic parameters such as the frequency. Such base functions are more numerically robust and are able to handle a poor selection of reference data. Muntz-Laguerre functions are further also able to handle the frequency-dependant behaviour of complex structures with its highly dynamic behaviour which is due to resonances and coupling effects.

Optionally, the method for generating a model of a multivariate system according to the present invention further comprises the steps of:

- freezing one or more of the property parameters; and
- using the multivariate system model in a simulation device.

This way, by freezing one or multiple parameters, the influence of the remaining parameters can be studied using one and the same multivariate model. Indeed, once the multivariate system model of a multivariate system is known, it is possible to generate a number of different models for use in a simulation device. Such models may then differ by the values for the frozen parameters, the parameters which are frozen or a combination thereof. It is obvious that the multivariate system model is able to provide a large range of models for various simulation devices without a lot of computational effort or high time requirements.

Further optionally, the simulation device is a software tool adapted to simulate one of the following:

- a SPICE model;
- a Verilog model;
- an I/O Buffer Information Specification (IBIS) model; and
- an ElectroMagnetic Transient Program (EMTP) model.

Researchers and designers often use models of complex systems to reduce the required effort in designing, analyzing or optimizing these complex systems. Models typically rely on a smaller number of parameters than a complex system and allow the abstraction of such complex systems. A large number of tools was created in order to further facilitate the use of models in the design, analysis and optimization of a complex system. For instance simulator software able to simulate Simulation Program with Integrated Circuit Emphasis (SPICE) models, Verilog or Verilog-A models, I/O Buffer Information Specification (IBIS) models, ElectroMagnetic Transient Program (EMTP) models, etc. are wide spread amongst researchers and designers. Their knowledge of such tools and their habit of working with such tools further improves their efficiency when designing, analyzing or optimizing a complex system.

It is therefore beneficial that the multivariate model obtained through the method of the present invention can be reduced to models which may be used in a wide range of simulation tools. Typically the simulation tools such as a Verilog-A or SPICE simulator are used to analyze the behaviour of a system with dynamic parameters. As such, it may be beneficial to freeze one or more property parameters and retain the dynamic parameters as variable parameters in the SPICE or Verilog model.

Optionally, the method for generating a model of a multi-port multivariate system according to the present invention further comprises the step of making poles of the multi-port multivariate system coincide.

Optionally, the reference data in the method for generating a multivariate system model according to the present invention are complex data.

In the prior art solution from A. Cuyt et al., the real parts and the imaginary parts of complex reference data are modelled independently. As mentioned before, this works in a mathematical approach. However, the present invention aims at meaningful results in other fields of technology such as control theory and system theory. These fields rely on the location of complex poles to determine the stability of a system. It is therefore beneficial to use complex reference data in the method of the present invention as this provides a multivariate system model which provides accurate information concerning the location of complex poles and thus satisfies the causality of the system.

Optionally, the iteratively determining a value for the explicit weight factors in the method according to the present invention uses a Sanathanan-Koerner iteration.

Minimizing the cost function to approximate the reference data with the model may be a non-linear problem. To overcome the complexity of solving such a non-linear problem, the Sanathanan-Koerner iteration procedure may be used. The Sanathanan-Koerner iteration reduces the non-linear problem to a linear approximation.

The present invention further relates to a device for generating a model of a multivariate system according to the method of the present invention.

### Brief Description of the Drawings

Fig. 1a and 1b is a graph illustrating a multivariate system modelled according to an embodiment of the method according to the present invention; and
Fig. 2 is a flow diagram of an embodiment of the method according to the present invention.

### Detailed Description of Embodiment(s)

As a first example, the method of the present invention will be illustrated with a mathematical approach. The goal of the method is to obtain a multivariate system model:

$$R\left(s,\vec{g}\right) \tag{1}$$

This model (1) consists of a numerator

$$N\left(s,\vec{g}\right) \tag{2}$$

and a denominator

$$D\left(s,\vec{g}\right) \tag{3}$$

In other words, the multivariate system model can be represented as follows:

$$R\left(s,\vec{g}\right) = \frac{N\left(s,\vec{g}\right)}{D\left(s,\vec{g}\right)} \tag{4}$$

Herein:

- s represents the complex frequency and $s = j\omega$ ; and
- $\overline{g}$ represents a vector of property parameters.

The multivariate system model (4) approximates a set of K+1 data samples, K being an integer value, in a least-squares sense. The numerator (2) and denominator (3) can each be rewritten in a more extensive form resulting in the following formula:

$$R(s,\vec{g}) = \frac{N(s,\vec{g})}{D(s,\vec{g})} = \frac{\sum_{p=0}^{P} \sum_{\vec{v}\in V} c_{p\vec{v}} \phi_p(s) \varphi_{\vec{v}}(\vec{g})}{\sum_{p=0}^{P} \sum_{\vec{v}\in V} \tilde{c}_{p\vec{v}} \phi_p(s) \varphi_{\vec{v}}(\vec{g})} \tag{5}$$

In formula (5):

- the variable s again represents the complex frequency;
- $\phi_p(s)$ represents the frequency dependant base function;
- P represents the maximal order of the frequency dependant base functions $\phi_p(s)$;
- p represents an index value ranging from 0 to the maximal order P;

- V represents V represents a set which contains all the distinct tuples $\bar{v}$ with non-negative multi-indices

$$\{(v_1, \ldots, v_N) \mid \{0 \leq v_n \leq V_n\}_{n=1}^{N}\} ;$$

- $V_n$ represents the maximal order of the univariate base functions corresponding to property parameter $g^{(n)}$ ; and
- $V_n$ represents an index value ranging from 0 to the maximal order $V_n$, $V_n$ being an integer value.
- $\varphi_{\bar{v}}(\bar{g})$ represents a multivariate base function which depends on a parameter vector $\bar{g}$ which contains N property parameters, N being an integer value;
- $c_{p\bar{v}}$ and $\tilde{c}_{p\bar{v}}$ represent the coefficients for the selected base functions of the numerator and denominator respectively.

The parameters of the multivariate model (5) need to be identified using an identification algorithm. The purpose of this algorithm is to find the optimal values for the coefficients $c_{p\bar{v}}$ and $\tilde{c}_{p\bar{v}}$. This is done by minimizing for instance the following $L_2$-norm:

$$\left\| R(s,\vec{g})_k - H(s,\vec{g})_k \right\|_2 \tag{6}$$

Herein:

- H represents the transfer function of the multivariate system; and
- k represents an index value ranging from 0 to K.
  To convert this non-linear minimization problem into a linear problem, the iterative Sanathanan-Koerner procedure is used. The iteration starts with the initial step at t = 0 where Levi's estimator is used to find an initial value of the model parameters. This initial value may be biased and will therefore be adapted each iteration. The initial value forms part of the model of the multivariate system which eventually is converted to the multivariate system model. The initial values are obtained by minimizing the cost function:

$$\min_{c_{p\bar{v}}, \tilde{c}_{p\bar{v}}} \sum_{k=0}^{K} \left| D(s,\vec{g})_k H(s,\vec{g})_k - N(s,\vec{g})_k \right|^2 \tag{7}$$

The cost function (7) can be rewritten as a set of equations wherein each column represents a particular base function and each line represents the reference data. Each line can then be weighted with explicit weight facros. This cost function and the minimization thereof results in an estimate of $c_{p\bar{v}}$ and $\tilde{c}_{p\bar{v}}$. The denominator $D(s,\bar{g})$ can be used as an inverse weighting factor based on these estimated values. For each of the subsequent iteration steps (t = 1, ...,

T) updated values for the model coefficients $c_{p\bar{v}}^{(t)}$ and $\tilde{c}_{p\bar{v}}^{(t)}$ can be found according to the formula:

$$\min_{c^{(t)}{}_{p\vec{v}},\tilde{c}^{(t)}{}_{p\vec{v}}} \sum_{k=0}^{K} \left| \frac{N^{(t)}(s,\vec{g})_k}{D^{(t-1)}(s,\vec{g})_k} - \frac{D^{(t)}(s,\vec{g})_k}{D^{(t-1)}(s,\vec{g})_k} H(s,\vec{g})_k \right|^2 \qquad (8)$$

The trivial null solution can be avoided by adding a non-triviality constraint such as an additional row in the system matrix. Such constraint imposes that the denominator approaches a non-zero value for the denominator without fixing any coefficient. The equation

$$\Re\left( \sum_{k=0}^{K} \frac{D^{(t)}(s,\vec{g})_k}{D^{(t-1)}(s,\vec{g})_k} \right) = K+1 \qquad (9)$$

has a weighting in relation to the size of the data. This improves the accuracy of the results if the reference data are noisy. To ensure that the weight coefficients $c^{(t)}{}_{p\overline{v}}$ and $\tilde{c}^{(t)}{}_{p\overline{v}}$ are real, each equation is split in its real and imaginary part. This results in the following cost function:

$$\min_{c^{(t)}_{p\vec{v}},\tilde{c}^{(t)}_{p\vec{v}}} \left( \sum \left| \Re e\left(e_1^{(t)}\right) \right|^2 + \left| \Im m\left(e_1^{(t)}\right) \right|^2 + \left| \Re e\left(e_2^{(t)}\right) \right|^2 \right) \qquad (10)$$

with

$$e_1^{(t)} = \frac{N^{(t)}(s,\vec{g})_k}{D^{(t-1)}(s,\vec{g})_k} - \frac{D^{(t)}(s,\vec{g})_k}{D^{(t-1)}(s,\vec{g})_k} H(s,\vec{g})_k \qquad (11)$$

and

$$e_2^{(t)} = \frac{\|H(s,\vec{g})\|}{K+1} \left( \sum_{k=0}^{K} \frac{D^{(t)}(s,\vec{g})_k}{D^{(t-1)}(s,\vec{g})_k} \right) - \|H(s,\vec{g})\| \qquad (12)$$

The columns of linear equations resulting from 10 may further be scaled to unit length to improve the numerical accuracy of the results.

Another important step in the modelling is the selection of the base functions which will be combined into the multivariate model. Effects such as resonance and coupling result in a highly dynamic behaviour of complex structures that have the frequency as parameter. In order to model such highly dynamic behaviour, the base functions for $\phi_p(s,\overline{a})$ are chosen from the Muntz-Laguerre orthonormal rational base functions. The functions are selected based on predefined stable poles in the vector $\vec{a} = \left\{ -a_p \right\}_{p=1}^{P}$ with $\phi_0(s) = 1$. Herein, -ap represents the pole with index p, p which ranges from 1 to the maximal order P.

In case $-a_p$ is real, the base functions are defined as:

$$\phi_p(s,\vec{a}) = \frac{\sqrt{2\Re e(a_p)}}{s+a_p} \left( \prod_{i=1}^{p-1} \frac{s-a_i^*}{s+a_i} \right) \qquad (13)$$

If $-a_{p+1} = -a^*_p$, a combination of two base functions is formed as follows:

$$\phi_p(s,\vec{a}) = \frac{\sqrt{2\Re e(a_p)}(s - |a_p|)}{(s + a_p)(s + a_{p+1})}\left(\prod_{i=1}^{p-1}\frac{s - a_i^*}{s + a_i}\right) \tag{14}$$

and

$$\phi_{p+1}(s,\vec{a}) = \frac{\sqrt{2\Re e(a_p)}(s + |a_p|)}{(s + a_p)(s + a_{p+1})}\left(\prod_{i=1}^{p-1}\frac{s - a_i^*}{s + a_i}\right) \tag{15}$$

The base functions for modelling the property parameters can be selected from polynomial base functions or rational base functions. Changes in property parameters often result in smooth variations in the model which indicates that the base functions for the property parameters $\varphi(\overline{g})$ are typically of relatively low order. A suitable choice for the base functions is thus a set of polynomial base functions depending on a real variable $g^{(n)}$. A good example is a power series as base functions. Alternatively, orthogonal Chebyshev polynomials may be used as base functions.

An alternative choice of base functions for the property parameters are rational base functions. These base functions are able to model a higher order in case the property parameters require this. The rational base functions corresponding to property parameter $g^{(n)}$ are based on a set of predefined poles:

$$\vec{b}^{(n)} = \left\{ -b_{v_n}^{(n)} \right\}_{v_n=1}^{V_n} \tag{16}$$

Herein:

-   $n$ represents an index ranging from 1 to N, N being an integer value;
-   $V_n$ represents the maximal order of the univariate base functions corresponding to property parameter $g^{(n)}$ ; and
-   $V_n$ represents an index value ranging from 1 to the maximal order $V_n$, $V_n$ being an integer value.

The poles $\overline{b}^{(n)}$ are chosen such that $b_{v_n+1}^{(n)} = -\left(b_{v_n}^{(n)}\right)^*$ . The corresponding base functions are then defined as follows:

$$\varphi_{v_n}\left(g^{(n)}, \vec{b}^{(n)}\right) = \left(jg^{(n)} + b_{v_n}^{(n)}\right)^{-1} - \left(jg^{(n)} - \left(b_{v_n}^{(n)}\right)^*\right)^{-1}$$

$$\varphi_{v_n}\left(g^{(n)}, \vec{b}^{(n)}\right) = \frac{2\Re e\left(b_{v_n}^{(n)}\right)}{\left(g^{(n)}\right)^2 - 2\Im m\left(b_{v_n}^{(n)}\right)g^{(n)} + \left|b_{v_n}^{(n)}\right|^2} \tag{17}$$

and:

$$\varphi_{v_n+1}\left(g^{(n)}, \vec{b}^{(n)}\right) = j\left(jg^{(n)} + b_{v_n}^{(n)}\right)^{-1} + j\left(jg^{(n)} - \left(b_{v_n}^{(n)}\right)^*\right)^{-1}$$

$$\varphi_{v_n+1}\left(g^{(n)}, \vec{b}^{(n)}\right) = \frac{2g^{(n)} - 2\Im m\left(b_{v_n}^{(n)}\right)}{\left(g^{(n)}\right)^2 - 2\Im m\left(b_{v_n}^{(n)}\right)g^{(n)} + \left|b_{v_n}^{(n)}\right|^2} \tag{18}$$

with $\varphi_0(g^{(n)},\overline{b}^{(n)})= 1$.

In these expressions j represents the imaginary unit and * denotes the complex conjugate.

The starting poles as mentioned above have to be selected. Their selection differs for dynamic parameters and property parameters. The starting poles for dynamic parameter related base functions $\phi_p(s,\overline{a})$ are chosen according to a heuristical scheme:

$$-a_p = -\alpha_p + j\beta_p, -a_{p+1} = -\alpha_p - j\beta_p \qquad (19)$$

and

$$\{\alpha_p\}= 0.01\{\beta_p\} \qquad (20)$$

The selected poles are typically complex conjugate pairs with small real parts and the imaginary parts are linearly spread over the frequency range of interest. The starting poles for the property parameters have no need for complex conjugacy and are selected according to:

$$-b_{v_n}^{(n)} = -\alpha_{v_n} + j\beta_{v_n}, -b_{v_n+1}^{(n)} = \alpha_{v_n} + j\beta_{v_n} \qquad (21)$$

and

$$\{\alpha_{v_n}\}= 0.01\{\beta_{v_n}\} \qquad (22)$$

These selected poles are linearly spaced over the property parameter range of interest.

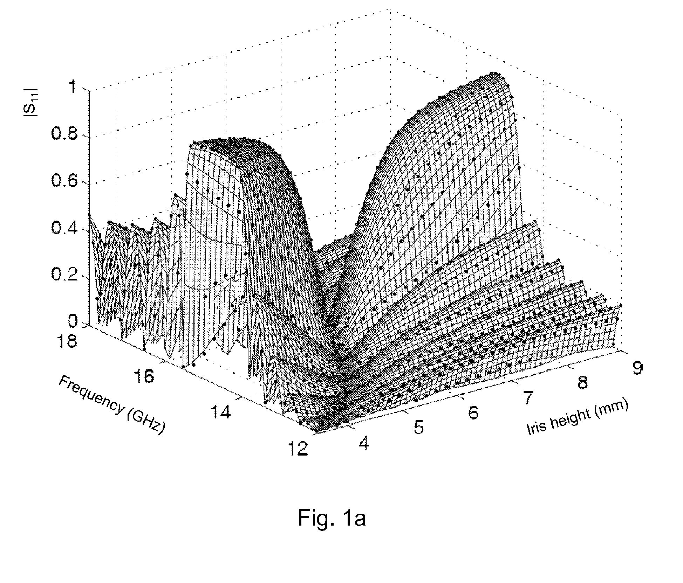

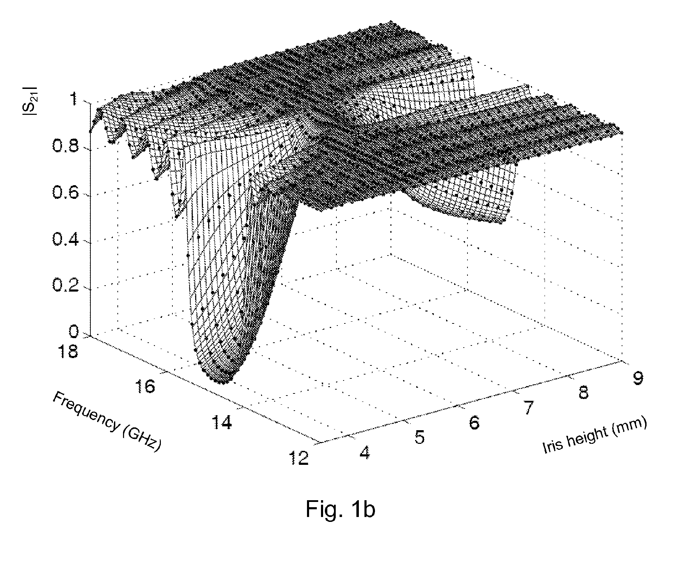

The results of modelling a multivariate system according to the present invention are illustrated in Fig. 1a and 1b for a system of two irises placed equidistantly in a two-dimensional space The reflection coefficient $S_{11}$ as illustrated in Fig. 1a and the transmission coefficient $S_{21}$ which is illustrated in Fig. 1b are computed. A multivariate model is then generated based on a dense set of reference data and more in particular a dense set of S-parameter data samples. The parameters of the multivariate model are the iris height over a frequency range. In this particular example, the dynamic behaviour is modelled using 34 complex conjugate starting poles and the geometrical parameter is modelled using 18 complex starting poles. To obtain an accurate multivariate system model, the approximation error between the model and the reference data should be -60dB or smaller or 3 significant digits. By applying the method of the present invention and performing 4 iterations, the behaviour of $S_{11}$ and $S_{21}$ is modelled with an approximation error of respectively - 68.1680 dB and -68.9127 dB. The responses of the multivariate model based on a much denser set of reference data than described above is shown in Fig. 1 a and 1 b.

Fig. 2 illustrates an embodiment of the method 200 according to the present invention using a flow diagram. In this particular embodiment reference data are obtained in step 201 using a number of simulations and measurements on the multivariate system. Once the reference data are available, a series of base functions are selected in step 202. These base functions are selected in such a way that they are suited to represent the dynamic behaviour of the parameters, e.g. Muntz-Laguerre base functions to model highly dynamic parameters and polynomial base functions to handle property parameters. In step 203 the selected base functions are combined to form a model of the multivariate system. The model obtained in step 203 is expected to change in subsequent steps of the method 200. In step 204 an initial weight is assigned to the cost function of step 205. Step 205 is the minimization of the cost function to approximate the reference data with the model. In step 206, an updated model is obtained which reflects the minimization of the cost function of step 205. The accuracy of the model is assessed in step 207. If the model approximates the reference data sufficiently, such as within predefined limits, after a number of iterations, when the time required for further iterations exceeds a time limit, etc, the multivariate system model is obtained in step 208. If the approximation is insufficient, the model coefficients are used to update the weight in step 204 and the procedure is repeated iteratively.

Although the present invention has been illustrated by reference to a specific embodiment, it will be apparent to those skilled in the art that the invention is not limited to the details of the foregoing illustrative embodiments, and that the present invention may be embodied with various changes and modifications without departing from the spirit and scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the spirit and scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. It is to be understood that the terms so used are interchangeable under appropriate circumstances and embodiments of the invention are capable of operating according to the present invention in other sequences different from the one(s) described or illustrated above.

**Claims**

**1.** A method (200) for generating a multivariate system model of a multivariate system, said multivariate system having a plurality of parameters and said multivariate system model being representative for the system response to changes in said parameters, said method comprising the steps of:

- performing a plurality of measurements and/or simulations on said multivariate system to obtain reference data (201);
- selecting rational base functions (202);
- combining said base functions (203) into a model of said multivariate system; and
- minimizing a cost function (205) between said model and said reference data to obtain said multivariate system model (208) of said multivariate system,

**characterized in that** said method (200) further comprises the steps of:

- using explicit weight factors related to said reference data in said cost function;
- as part of minimizing said cost function, iteratively determining updated values for said explicit weight factors (205) in said cost function in order to approximate said reference data with said model; and
- updating said cost function with said updated values for said explicit weight factors in each iteration.

**2.** The method (200) for generating a multivariate system model of a multivariate system according to claim 1, **characterized in that** said rational base functions are orthonormal rational base functions.

**3.** The method (200) for generating a multivariate system model of a multivariate system according to claim 1, **characterized in that** said plurality of parameters comprises one or more dynamic parameters and/or one or more property parameters.

**4.** The method (200) for generating a multivariate system model of a multivariate system according to claim 3, **characterized in that** said dynamic parameters are one or more of the following:

- frequency; and
- spatial frequency; and said method being further **characterized in that** said property parameters are one or more of the following:
- geometrical parameters; and
- material characteristics;

**5.** The method (200) for generating a multivariate system model of a multivariate system according to claim 3, **characterized in that** said base functions are rational functions, Muntz-Laguerre functions, Kautz functions or pole-residue functions for said dynamic parameters and said base functions are rational or polynomial functions for said property parameters.

6. The method (200) for generating a multivariate system model of a multivariate system according to claim 3, **characterized in that** said method comprises the steps of:

 - freezing one or more of said property parameters; and
 - using said multivariate system model in a simulation device.

7. The method (200) for generating a multivariate system model of a multivariate system according to claim 6, **characterized in that** said simulation device is a software tool adapted to simulate one of the following:

 - a SPICE model;
 - a Verilog model;
 - an I/O Buffer Information Specification IBIS model; and
 - an ElectroMagnetic Transient Program EMTP model.

8. The method (200) for generating a multivariate system model of a multivariate system according to claim 1, **characterized in that** said method (200) comprises the step of making poles of said multivariate system coincide.

9. The method (200) for generating a multivariate system model of a multivariate system according to claim 1, **characterized in that** said reference data are complex data.

10. The method (200) for generating a multivariate system model of a multivariate system according to claim 1, **characterized in that** said iteratively determining a value for said explicit weight factors uses a Sanathanan-Koerner iteration.

11. A device for generating a multivariate system model of a multivariate system according to the method (200) of claim 1.

Fig. 1a

Fig. 1b

200

```
┌─────────────────────────────────┐
│     Obtain reference data        │          201
└─────────────────────────────────┘
                │
                ▼
┌─────────────────────────────────┐
│   Select rational base functions │          202
└─────────────────────────────────┘
                │
                ▼
┌─────────────────────────────────┐
│      Combine rational base       │
│      functions into model        │          203
└─────────────────────────────────┘
Iteration step t =0  │
                ▼
┌─────────────────────────────────┐
│  Select (t=0) or Update (t>0) expli- │      204
│  cit weighting of the cost function  │◄─────┐
└─────────────────────────────────┘          │
                │                             │
                ▼                             │
┌─────────────────────────────────┐          │
│  Minimize weighted cost function │          205
│  between model and reference data│          │
└─────────────────────────────────┘       ┌──────┐
                │                          │t=t+1 │
                ▼                          └──────┘
┌─────────────────────────────────┐          │
│      Obtain Updated Model        │          206
└─────────────────────────────────┘          │
                │                             │
                ▼                    NO       │
         ╱─────────────╲ ────────────────────┘
        ╱ Model accurate? ╲                   207
         ╲─────────────╱
                │
              YES
                ▼
┌─────────────────────────────────┐
│     Obtain Multivariate          │          208
│     System model                 │
└─────────────────────────────────┘
```

Fig. 2

EP 2 051 175 A1

## EUROPEAN SEARCH REPORT

Application Number

EP 07 11 8724

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROBERT LEHMENSIEK ET AL: "Creating Accurate Multivariate Rational Interpolation Models of Microwave Circuits by Using Efficient Adaptive Sampling to Minimize the Number of Computational Electromagnetic Analyses" IEEE TRANSACTIONS ON MICROWAVE THEORY AND TECHNIQUES, IEEE SERVICE CENTER, PISCATAWAY, NJ, US, vol. 49, no. 8, August 2001 (2001-08), XP011038377 ISSN: 0018-9480 | 1-5,8-11 | INV. G06F17/50 |
| Y | * the whole document * | 6,7 | |
| D,A | CUYT A ET AL: "Adaptive multivariate rational data fitting with applications in electromagnetics" IEEE TRANSACTIONS ON MICROWAVE THEORY AND TECHNIQUES IEEE USA, vol. 54, no. 5, May 2006 (2006-05), pages 2265-2274, XP002463191 ISSN: 0018-9480 * the whole document * | 1-11 | |
| Y | DIRK DESCHRIJVER ET AL: "Orthonormal Vector Fitting: A Robust Macromodeling Tool for Rational Approximation of Frequency Domain Responses" IEEE TRANSACTIONS ON ADVANCED PACKAGING, IEEE SERVICE CENTER, PISCATAWAY, NJ, US, vol. 30, no. 2, May 2007 (2007-05), pages 216-225, XP011182369 ISSN: 1521-3323 the whole document; in particular last paragraph of section "VI. Conclusion" * the whole document * | 6,7 | TECHNICAL FIELDS SEARCHED (IPC) G06F |

-/--

The present search report has been drawn up for all claims

| Place of search | Date of completion of the search | Examiner |
|---|---|---|
| Munich | 20 December 2007 | Lerbinger, Klaus |

15

**European Patent Office**

**EUROPEAN SEARCH REPORT**

Application Number

EP 07 11 8724

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DESCHRIJVER D ET AL: "Advancements in iterative methods for rational approximation in the frequency domain" IEEE TRANSACTIONS ON POWER DELIVERY IEEE USA, vol. 22, no. 3, July 2007 (2007-07), pages 1633-1642, XP002463192 ISSN: 0885-8977 * the whole document * ----- | 1-11 | |
| A | SOREN F PEIK ET AL: "Multidimensional Cauchy Method and Adaptive Sampling for an Accurate Microwave Circuit Modeling" IEEE TRANSACTIONS ON MICROWAVE THEORY AND TECHNIQUES, IEEE SERVICE CENTER, PISCATAWAY, NJ, US, vol. 46, no. 12, December 1998 (1998-12), XP011037425 ISSN: 0018-9480 * the whole document * ----- | 1-11 | TECHNICAL FIELDS SEARCHED (IPC) |

The present search report has been drawn up for all claims

| Place of search | Date of completion of the search | Examiner |
|---|---|---|
| Munich | 20 December 2007 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ANNIE CUYT.** Adaptive Multivariate Rational Data Fitting With Applications in Electromagnetics. *IEEE transactions on microwave theory and techniques,* 05 May 2006, vol. 54 (5